# EUROPEAN PATENT SPECIFICATION

(11) **EP 0 428 359 B1**
(45) Date of publication and mention of the grant of the patent: **14.09.1994**
(21) Application number: 90312326.3
(22) Date of filing: 12.11.1990
(51) Int. Cl.: H01R 23/70

(54) **Connector for electric parts**
Verbinder für elektrische Teile
Connecteur pour pièces électriques

(30) Priority: 14.11.1989 JP 295438/89
(43) Date of publication of application: 22.05.1991
(73) Proprietor: Yamaichi Electronics Co., Ltd., Ohta-ku Tokyo (JP)
(72) Inventor: Matsuoka, Noriyuki, Shinagawa-ku, Tokyo (JP); Uratsuji, Kazumi, Ohta-ku, Tokyo (JP)
(74) Representative: Ben-Nathan, Laurence Albert

(56) References cited:
- GB-A- 2 218 277
- US-A- 4 410 928
- US-A- 4 713 014

## Description

This invention relates to a connector for connecting an electric part, to a wiring board according to the pre-characterizing part of claims 1 and 2.

Such a conventional connector in which the leg portions of contacts penetrate a locator and then penetrate a wiring board is disclosed in Japanese Utility Model Publication No. Sho 45-5567 in which the locator is provided with a guide hole of the plate type.

However, this prior art had the following inconveniences. That is, when the connector for an electric part is placed on a printed circuit board, the printed circuit board and the connector for an electric part, or the connector and the locator must be held in a horizontal state. In this case, the locator tends to incline or escape from the leg portion because one side of the locator is displaced due to gravity. This naturally causes an incorrect positioning of the tip of the terminal and requires that the locator is returned to the position of the tip of the leg portion in order to perform the same work all over again.

Also, when the connector for an electric part is placed on the printed circuit board, the connection hole of the printed circuit board become a dead angle of the connector body for an electric part and the locator and therefore, it is very difficult to correctly face the guide hole of the locator and the connection hole of the printed circuit board with respect to each other while holding the printed circuit board and the connector for an electric part in their inclined states. Moreover, when the operator tries to confirm the connection hole of the printed circuit board by inclining the connector for an electric part, the locator is readily inclined and/or escaped therefrom.

Furthermore, when the operator tries to confirm the connection hole of the printed circuit board without inclining the connector for an electric part, it is necessary to locate the neighborhood of the connection hole of the printed circuit board by the tip of the leg portion of the connector for an electric part. Accordingly, there is such a fear as that the wiring of the printed circuit board is scratched and cut off by mistake.

The present invention was accomplished in order to obviate the above-mentioned inconveniences.

### SUMMARY OF THE INVENTION

It is therefore an object of the present invention to provide a connector for an electric part including means for temporarily fixing or resiliently holding a locator in order to facilitate a smooth and prompt mounting operation to a printed circuit board.

It is another object of the present invention to provide a connector for an electric part, in which the wiring of the printed circuit board is not scratched and cut off when the connector is mounted on a printed circuit board.

These objects are achieved by the two embodiments according to claims 1 and 2 respectively.

According to the present invention, since the locator can be moved between a first position close to the connector board and a second position away from the connector board, and the locator can be temporarily fixed to or resiliently held in the second position away from the connector board, the tip position of the leg portion can effectively be restricted by the locator. This is very advantageous when the connector for an electric part is mounted on a printed circuit board.

Furthermore, according to one embodiment of the present invention, since the locator is provided with a positioning pin, the tip of the leg portion can be correctly positioned with respect to the printed circuit board in order to properly guide the insertion of the leg portion before the tip of the leg portion contacts the printed circuit board. As a result, when the leg portion is inserted, the wiring of the printed circuit board can be prevented from being scratched and cut off.

### BRIEF DESCRIPTION OF THE DRAWINGS

The above and other objects, features and advantages of the present invention will become more manifest to those skilled in the art from the following detailed description of the invention with reference to the accompanying drawings, wherein:
Fig. 1 is a plan view of a connector for an electric part according to one embodiment of the present invention;
Fig. 2 is a bottom view thereof;
Fig. 3 is a perspective view of a locator of the connector for an electric part according to one embodiment of the present invention;
Figs. 4(A) and 4(B) are sectional views taken on line A-A of Fig. 1, Fig. 4(A) is a view before mounting, and Fig. 4(B) is a view after being mounted;
Figs. 5(A) and 5(B) are sectional views taken on line A-A of Fig. 1 showing a connector for an electric part according to another embodiment of the present invention, Fig. 5(A) is a view before mounting and Fig. 5(B) is a view after being mounted;
Fig. 6 is a sectional view taken on line B-B of the above embodiment (after being mounted);
Figs. 7(A) and 7(B), are sectional views taken on line A-A of a connector for an electric part according to still another embodiment of the present invention, Fig. 7(A) is a view before mounting and Fig. 7(B) is a view after being mounted; and
Figs. 8(A) and 8(B) are sectional view taken on line A-A of a connector for an electric part according to yet another embodiment of the present invention, Fig. 8(A) is a view before mounting and Fig. 8(B) is a view after being mounted.

### DETAILED DESCRIPTION OF THE INVENTION

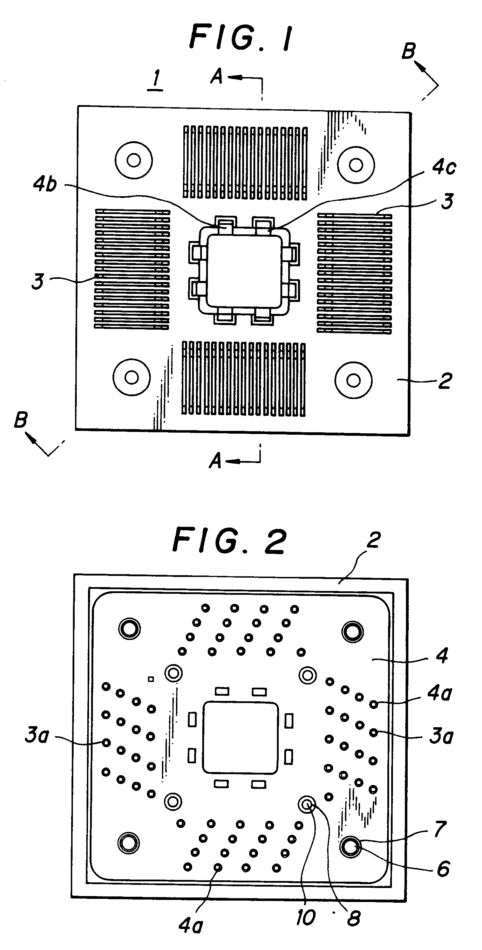

The embodiments of the present invention will now be described with reference to Figs. 1 through 8.

Fig. 1 shows a plan view of a connector 1 for an electric part, which has a plurality of contacts 3 arranged on a connector board 2 and adapted to contact with an electric part.

Each of the contacts 3 has a leg portion 3a which projects outward from the connector board 2 so as to be connected with a wiring board 5.

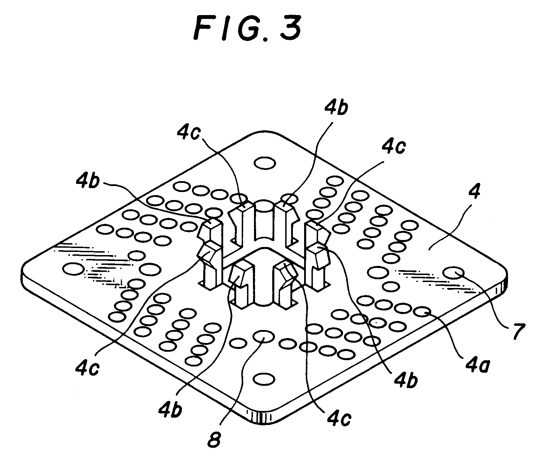

A projection surface of the connector board 2 from which the leg portions 3a project is provided with a locator 4 as shown in Fig. 3.

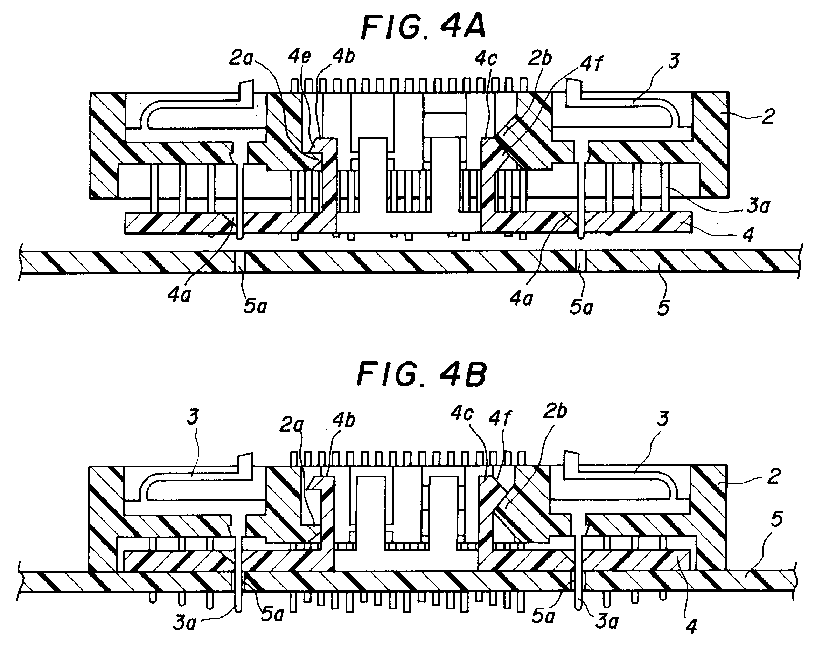

The locator 4 is provided with a plurality of leg portion guide holes 4a of the plate type adapted to receive the leg portions 3a and correctly position them. The locator 4 is further provided with temporarily fixing means for temporarily fixing the locator 4 in a position away from the leg projection surface of the connector board 2. The temporarily fixing means is provided with an engagement means disposed between the locator 4 and the connector board 2 and adapted to engage in a male and female engagement fashion at the position away from the connector board 2 and the locator 4 escapes and allowed to move when the engagement means exerts a compulsive moving force to the locator 4 in the approaching direction. As one concrete example, locator 4 is provided at a generally central portion thereof Wi th a plurality of depart stoppers 4b and approach stoppers 4c, all erected therefrom. The depart stoppers 4b, as shown in Fig. 4(A), are engaged with the connector board 2 as such that the locator 4 is permitted to move in the approaching direction and prohibited to move in the departing direction, while the approach stoppers 4c are abutted against the connector board 2 as such that the locator 4 is restricted to move in the approaching direction, thereby to depart the locator 4 by a predetermined length from the connector board 2 and the vicinities of the tip portions of the leg portions 3a of the contacts 3 are shallowly inserted into the guide holes 4a of the plate type of the locator 4 in order to correctly position to realize a temporarily fixed state. In the foregoing state, the locator 4 is correctly positioned relative to the wiring board 5. As is shown in Fig. 4(B), when the connector board 2 is pushed against the wiring board 5, the approach stoppers 4c are displaced against resiliency in order to cancel the abutment engagement, and cancels the temporary fixation of the locator 4. As a result, the connector board 2 is permitted to move toward the wiring board 5 and the leg portions 3a of the connector 1 for an electric part are inserted into the connection holes 5a of the wiring board 5. Thus, the connector 1 for an electric part is correctly mounted on the wiring board 5.

The depart stoppers 4b prevents the movement in the departing direction in such a manner as that engaging claws formed on the tips of the depart stoppers 4b are engaged with a retaining step portion 2a of the connector board 2. On the other hand, the approach stoppers 4c are brought into abutment with the connector board 2 while the depart stoppers 4b are in engagement with the connector board 2 and by exerting a compulsive force in the direction opposite to the engaging direction, it is permitted to climb over and allowed to move in the approaching direction to the connector board 2. For example, the projection 4f disposed at the tip of the approach stopper is abutted with the projection 2b formed on the connector board 2, and both the projections 4f and 2b are slipped to cancel the abutment engagement. As a result, there can obtain a state of Fig. 4(B) from Fig. 4(A) or Fig. 4(A) from Fig. 4(B). In the meantime, the locator 4 can be moved in the approaching and departing direction. The slip projections 4f and 2b are formed, for example, in a hill shape or arcuate shape having tapered upper and lower surfaces.

As described in the foregoing, the locator 4 can be moved between a first position close to the connector board 2 and a second position away from the connector board 2. The locator 4 is temporarily fixed in the second position away from the connector board 2 as shown in Fig. 4(A). On the other hand, when in the first position close to the connector board 2, the leg portions 3a are inserted into the connection holes 5a of the wiring board 5.

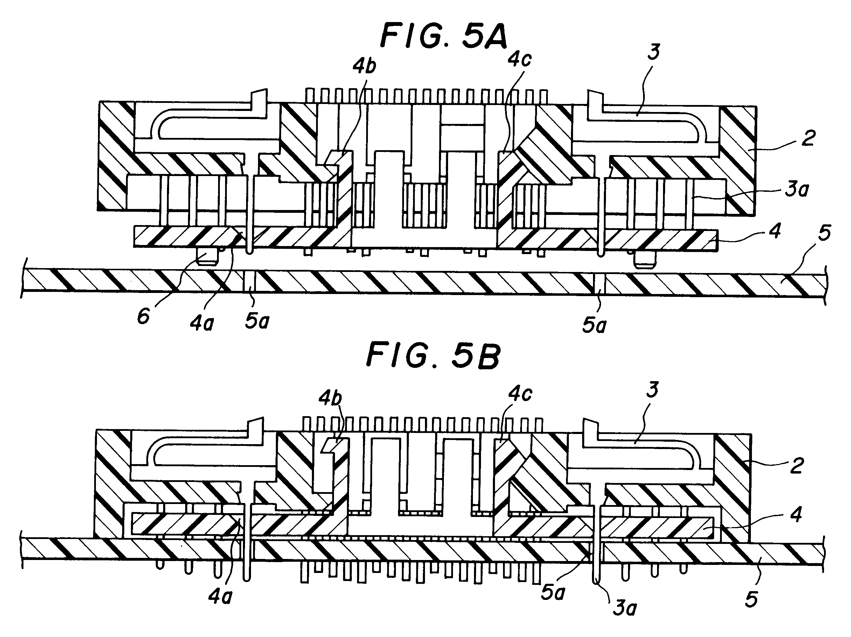

Figs. 5 through 6 show another embodiment of the connector 1 for an electric part. In this embodiment, positioning pins 6 to be inserted into the connecting holes 5a of the wiring board 5 are arranged on a projection surface of the locator 4 from which the leg portions 3a project. Each of the positioning pins 6 engage at its central portion with a fixing screw hole 7 penetrating the locator 4. The locator 4 is provided in the vicinity of its central portion with a reinforcing projection escape hole 8. On the other hand, the connector board 2 is provided in a position corresponding to the fixing screw hole 7 with a fixing screw insertion hole 9 in such a manner as to penetrate the board 2 and in a position corresponding to the reinforcing projection escape hole 8 with a reinforcing projection 10.

The positioning pin 6 is set as such that when the locator 4 is temporarily fixed in the second position away from the connector board 2, the tip of the positioning pin 6 is in a position (distant position) spaced apart from the tip of the leg portion 3a. Accordingly, when the locator 4 is inserted into the connecting hole 5a of the wiring board 5 and correctly positioned by the positioning pin 6, the inserting work of the leg portion can be performed without having the tip of the leg portion 3a contacted with the wiring board 5.

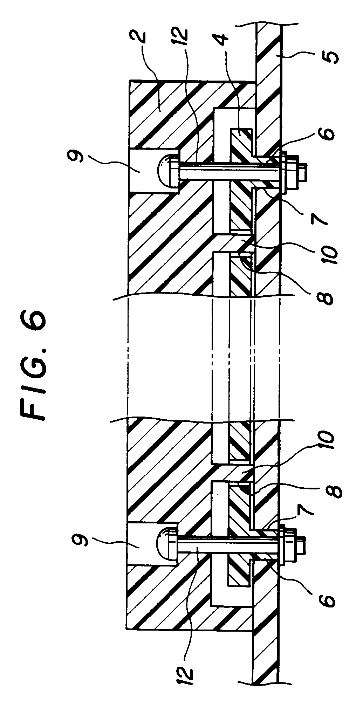

Furthermore, as is shown in Fig. 6, after the connector 1 for an electric part is mounted on the wiring board 5, they may be fixed by screws 12, etc. using the fixing screw hole 7 and the fixing screw inserting hole 9. In order to resist force for deforming the connector board 2 at that time, or at the time the connector 1 for an electric part is connected with another electric part, the reinforcing projection 10 contacts with the wiring board 5 in the vicinity of its central portion through the escape hole 8 of the locator 4, so that the strength of the wiring board 5 can also be utilized.

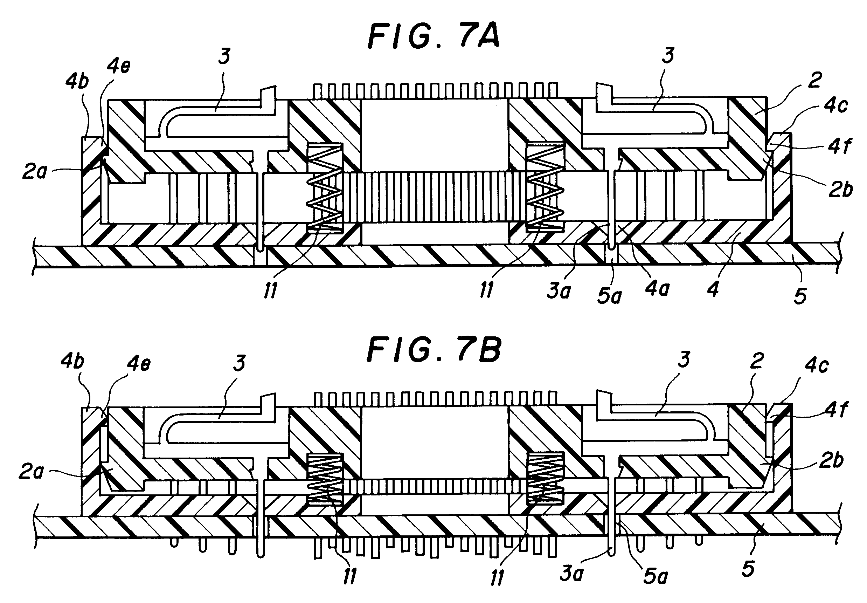

Figs. 7(A) and 7(B) show still another embodiment of a connector 1 for an electric part according to the present invention. In this embodiment, instead of the approach stopper, a coil spring 11 is interposed between the locator 4 and the connector board 2, and the depart stopper 4b is disposed in such a manner as to be able to engage With the outer peripheral portion of the connector board 2. That is, the locator 4 and the connector board 2 are separated away by a biasing force of the coil spring 11 and the locator 4 is temporarily fixed in a position away from the connector board 2 because the depart stopper 4b is engaged with the locator 4 in a position away from the connector board 2 by a predetermined distance.

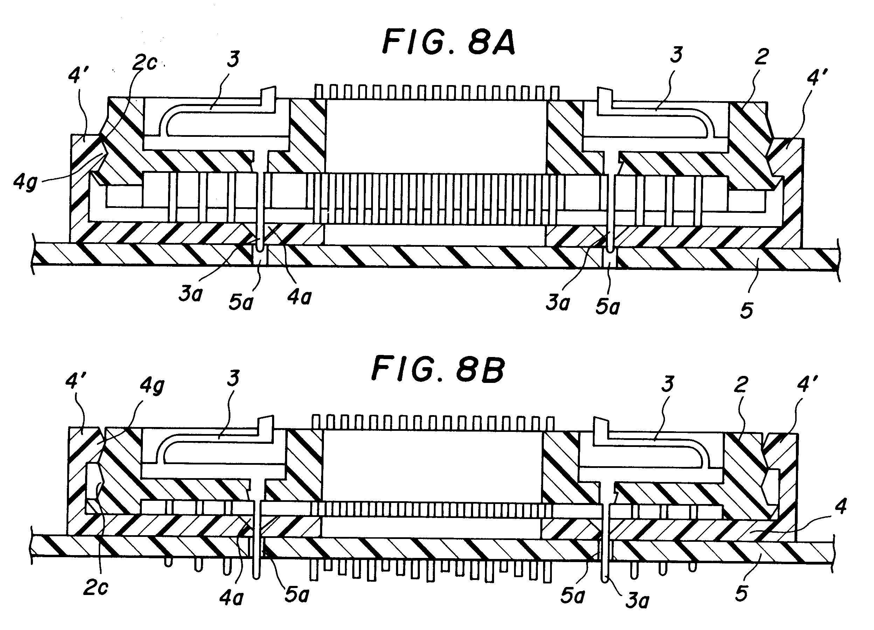

Figs. 8(A) and 8(B) show yet another embodiment of a connector 1 for an electric part according to the present invention. In this embodiment, the depart stopper 4b and the approach stopper 4c are formed as one body engageable with the outer peripheral portion of the connector 1 for an electric part.

That is, the locator 4 is provided with temporarily fixing elements 4′ each erected from one end and the other end of the locator 4 and each of the temporarily fixing elements is provided with an engaging projection 4g. On the other hand, a side surface of one end of the connector board 2 and a side surface of the other end are provided with a recess portion 2c respectively so that the engaging projection 4g can be engaged in the corresponding recess portion 2c. As is shown in Fig. 8(A), when the engaging projection 4g is in engagement with the recess portion 2c, the second position of the locator 4 away from the connector board 2 is maintained and the engaging projection 4g escapes from the engaging recess portion 2c for permitting the locator 4 to move in the approaching direction.

When the locator 4 is temporarily fixed to or resiliently held in the second position away from the connector board 2, at least two leg portions 3a project from the leg portion guide holes 4a of the locator 4. Otherwise, the tip of the leg portion 3a is shallowly inserted in the leg portion guide hole 4a such that the tip does not project therefrom or the tip of the leg portion 3a is held in a position immediately before inserting into the guide hole 4a. And in the foregoing state, the locator 4 is temporarily fixed or resiliently held.

As described in the foregoing, according to the present invention, the tip position of the leg portion can be reliably restricted by the locator temporarily fixed to or resiliently held in the position away from the connector board. Also, by holding the locator in its horizontal state by means of the afore-mentioned temporary fixing or resilient holding arrangement, the mounting work of the connector for an electric part to the printed circuit board can be performed correctly and rapidly.

Also, by means of the positioning pin for correctly positioning the locator to the wiring board, the mounting work can be simplified, and the wiring of the printed circuit board is not scratched and cut off when the contact leg portions are inserted.

Also, by making the position of the positioning pin for the locator and the position of the fixing screw for the connector for an electric part the same, the above-mentioned improvement can be obtained without forming extra holes in the printed circuit board, and the degree of freedom of wiring patterns of the printed circuit board is not lost, either.

Although several preferred embodiments of the present invention have been described, the present invention is not limited to these embodiments.

## Claims

1. A connector for connecting an electric part to a wiring board (5), comprising a connector board (2) including a plurality of contacts with leg portions (3a) projecting from the connector board (2), the connector further comprising a locator (4) provided with a plurality of leg portion positioning holes (4a) in which the leg portions penetrate individually and from which said leg portions project in order to be connected to the wiring board, said connector for an electric part being characterized in that said locator can be moved between a first position close to said connector board and a second position away from said connector board, and said connector further includes temporarily fixing means for temporarily fixing said locator in said second position away from said connector board.

2. A connector for connecting an electric part to a wiring board (5), comprising a connector board (2) including a plurality of contacts with leg portions (3a) projecting from the connector board (2), the connector further comprising a locator (4) provided with a plurality of leg portion positioning holes (4a) in which the leg portions penetrate individually and from which said leg portions project in order to be connected to the wiring board, said connector for an electric part being characterized in that said locator can be moved between a first position close to said connector board and a second position away from said connector board, and said locator is resiliently held in said second position away from said connector board.

3. A connector for an electric part as claimed in claim 1 or 2, wherein at least two of said leg portions project from said locator when said locator is temporarily fixed to or resiliently held in said second position away from said connector board.

4. A connector for an electric part as claimed in claim 1 or 2, wherein said leg portions do not project from said locator when said locator is temporarily fixed to or resiliently held in said second position away from said connector board.

5. A connector for an electric part as claimed in claim 1 or 2, wherein said locator is provided with a plurality of positioning pins formed on the surface from which said leg portions project and adapted to correctly position said locator relative to a printed circuit board.

6. A connector for an electric part as claimed in claim 5, wherein a screw for fixing said connector for an electric part can penetrate through said positioning pins of said locator.

7. A connector for an electric part as claimed in claim 5, wherein the tip of said positioning pin is in a more distant position from said connector board compared with the tip of said leg portion.

## Patentansprüche

1. Verbinder zum Anschließen eines elektrischen Teiles an eine Leiterplatte (5), bestehend aus einer Anschlußplatte (2) mit aus der Platte (2) vorspringenden Steckerstiften (3a) einer Mehrzahl von der Platte (2) zugeordneten Kontakten (3) mit einem mit Durchgängen (4a) für die Steckerstifte (3a) versehenen Führungsstück (4), dessen Durchgänge (4a) von den Steckerstiften (3a) individuell mit Überstand für die Herstellung der Anschlüsse an der Leiterplatte (5) durchsetzt werden, gekennzeichnet durch ein aus seiner unmittelbaren Anlage gegen die Anschlußplatte (2) in eine von der Anschlußplatte (2) beabstandete Position verlagerbares Führungsstück (4) und Fixierungsmittel zur vorübergehenden Festlegung des Führungsstücks (4) in seiner beabstandeten Position zur Anschlußplatte (2).

2. Verbinder zum Anschließen eines elektrischen Teiles an eine Leiterplatte (5), bestehend aus einer Anschlußplatte (2) mit aus der Platte (2) vorspringenden Steckerstiften (3a) einer Mehrzahl von der Platte (2) zugeordneten Kontakten (3) mit einem mit Durchgängen (4a) für die Steckerstifte (3a) versehenen Führungsstück (4), dessen Durchgänge (4a) von den Steckerstiften (3a) individuell mit Überstand für die Herstellung der Anschlüsse an der Leiterplatte (5) durchsetzt werden, gekennzeichnet durch ein aus seiner unmittelbaren Anlage der Anschlußplatte (2) in eine von der Anschlußplatte (2) beabstandete Position verlagerbares, in der zur Anschlußplatte (2) beabstandeten Position durch Federkraft fixierbares Führungsstück (4).

3. Verbinder zum Anschließen eines elektrischen Teils nach Anspruch 1 oder Anspruch 2, dadurch gekennzeichnet, daß mindestens zwei Steckerstifte (3a) eine Länge aufweisen, aus der sich ein Überstand der Steckerstifte (3a) über das Führungsstück (4) der beabstandeten Positionierung des Führungsstücks (4) zur Anschlußplatte (2) ergibt.

4. Verbinder zum Anschließen eines elektrischen Teils nach Anspruch 1, dadurch gekennzeichnet, daß sämtliche Steckerstifte (3a) eine Länge aufweisen, aus der eine beabstandete Positionierung des Führungsstücks (4) zur Anschlußplatte (2) ohne Steckerstift-Überstand resultiert.

5. Verbinder zum Anschließen eines elektrischen Teils nach einem der Ansprüche 1 bis 4, dadurch gekennzeichnet, daß das Führungsstück (4) auf der der Leiterplatte (5) zugewandten Seite mit einer Mehrzahl von über es vorspringenden Positionierungstiften (6) zur eindeutigen Zuordnung des Führungsstücks (4) zur Leiterplatte (5) versehen ist.

6. Verbinder zum Anschließen eines elektrischen Teils nach Anspruch 5, gekennzeichnet durch die Positionierungsstifte (6) durchsetzende Schrauben (12) zur Festlegung der Anschlußplatte (2) gegenüber der Leiterplatte (5).

7. Verbinder zum Anschließen eines elektrischen Teils nach Anspruch 5 oder Anspruch 6, dadurch gekennzeichnet, daß die Positionierungsstifte (6) eine Länge aufweisen, aus der - bei beabstandeter Positionierung des Führungsstücks (4) zur Anschlußplatte (2) - ein größerer Überstand der Positionierungsstifte (6) über das Führungsstück (4) als der der Steckerstifte (3a) resultiert.

## Revendications

1. Connecteur pour connecter un composant électrique à un panneau de câblage (5), comportant un panneau de connexion (2) incluant une pluralité de contacts avec des parties de pattes (3a) s'étendant à partir du panneau de connexion (2), le connecteur comportant en outre un positionneur (4) muni d'une pluralité de trous de positionnement (4a) des parties de pattes, dans lesquels les parties de pattes pénètrent individuellement et à partir desquels les parties de pattes s'étendent dans le but d'être connectées au panneau de câblage, ce connecteur pour composant électrique étant caractérisé en ce que le positionneur peut être déplacé entre une première position proche du panneau de connexion et une seconde position écartée du panneau de connexion, le connecteur comportant en outre des moyens de fixation temporaires pour temporairement fixer le positionneur dans la seconde position écartée du panneau de connexion.

2. Connecteur pour connecter un composant électrique à un panneau de câblage (5), comportant un panneau de connexion (2) incluant une pluralité de contacts avec des parties de pattes (3a) s'étendant à partir du panneau de connexion (2), le connecteur comportant en outre un positionneur (4) muni d'une pluralité de trous de positionnement (4a) de parties de pattes, dans lesquels les parties de pattes pénètrent individuellement et à partir desquels les parties de pattes s'étendent dans le but d'être connectées au panneau de câblage, le connecteur pour composant électrique étant caractérisé en ce que le positionneur peut être déplacé entre une première position à proximité du panneau de connexion et une seconde position écartée du panneau de connexion, et le positionneur est maintenu de manière élastique dans la seconde position écartée du panneau de connexion.

3. Connecteur pour composant électrique selon la revendication 1 ou 2, caractérisé en ce qu'au moins deux des parties de pattes s'étendent à partir du positionneur lorsque le positionneur est temporairement fixé à ou maintenu élastiquement dans la seconde position écartée du panneau de connexion.

4. Connecteur pour composant électrique selon la revendication 1 ou 2, caractérisé en ce que les parties de pattes ne s'étendent pas à partir du positionneur lorsque le positionneur est temporairement fixé à ou maintenu élastiquement dans la seconde position écartée du panneau de connexion.

5. Connecteur pour composant électrique selon la revendication 1 ou 2, caractérisé en ce que le positionneur est muni d'une pluralité de pieds de positionnement formés sur la surface à partir de laquelle les parties de pattes s'étendent, et servant à positionner correctement le positionneur par rapport à un panneau de circuit imprimé.

6. Connecteur pour composant électrique selon la revendication 5, caractérisé en ce qu'une vis pour fixer le connecteur pour composant électrique peut pénétrer à travers les pieds de positionnement du positionneur.

7. Connecteur pour composant électrique selon la revendication 5, caractérisé en ce que le bout du pied de positionnement est dans une position plus éloignée du panneau de connexion comparativement au bout de la partie de patte.
